# EUROPEAN PATENT SPECIFICATION

(11) **EP 0 469 663 B1**
(45) Date of publication and mention of the grant of the patent: **05.04.1995**
(21) Application number: 91201859.5
(22) Date of filing: 12.07.1991
(51) Int. Cl.: H03J 3/00, H01Q 1/27

(54) **Tuned radio receiving circuit**
Abgestimmter Radioempfänger
Récepteur radio accordé

(30) Priority: 03.08.1990 NL 9001765
(43) Date of publication of application: 05.02.1992
(73) Proprietor: ERICSSON RADIO SYSTEMS B.V., 7814 VA Emmen (NL)
(72) Inventor: Rutgers, Harm, NL-7873 AH Odoorn (NL)
(74) Representative: van der Arend, Adrianus G.A., Ir.

(56) References cited:
- EP-A- 0 334 297
- FR-A- 1 449 055
- GB-A- 2 117 182
- US-A- 4 862 181

## Description

The invention relates to a tuned radio receiving circuit comprising a parallel circuit of two reactances having opposite polarities, one of the reactances having terminals for connection to an amplifier component and comprising a series circuit of three parts having the same polarity, the amplifier component being connected across the centre part thereof.

A tuned radio receiving circuit of the type mentioned above is disclosed by French patent 1449055. The prior art receiving circuit is designed to be very selective to overcome a loss of a signal/noise ratio due to electrical parasites due to the symmetrical structure of an antenna circuit. Accordingly, with the prior art receiving circuit the amplifier component is very selective and coupled to the tuned parallel circuit by a wide band symmetrical transformer, while ferrite rods have been distributed against the inner circumference of a winding providing a receiving coil of said reactances, with their axis parallel to the axis of said coil.

It is an object of the invention to increase the sensitivity of the receiving circuit for a received useful signal against an interference signal generated by an interference source at an input of the amplifier component. This is particularly of interest in the field of small sized portable receiving units of a paging system, in which units such interference source is often close to said parallel circuit of two reactances thereby reducing the signal/noise ratio. This is in particular disadvantageous for such receiving units, since the transmission power permitted by nationally imposed regulations for transmitting the useful transmission signal is small and yet a reception area as large as possible is desired.

Portable receiving units of a paging system do not comprise a transformer in the receiving circuit thereof. However, connecting the amplifier component, in particular a transistor, directly to the parallel circuit of two reactances may result into a reduction of the signal/noise ratio and to a reduction of the Q factor or the sensitivity of the tuned circuit if the amplifier component has a low impedance increasing the load of the tuned parallel circuit, for which reasons the reception area of such receiving unit is limited.

It is an object of the invention to solve the above mentioned problems.

Said object is attained by the tuned radio receiving circuit described in claim 1.

Because the centre part of the one reactance has a smaller reactance value at the tuning frequency, that is to say a self-inductance forming said reactance has a smaller value or a capacitor has a larger value than the other two parts of the series circuit, an impedance transformation is thereby achieved and as a result of this the tuned circuit forms a low impedance for the amplifier component. Accordingly loss of the sensitivity of the circuit due to the amplifier component is limited. As the reactance values of the other two parts of the one reactance become smaller with respect to the centre part thereof, interference signal currents flowing in opposite direction through said other two parts cancel each other out less at the terminals of the amplifier component, but the received useful signal is suppressed less. As the reactance values of said other two parts become larger with respect to the centre part, however, the interference signal currents cancel each other out more, but the useful signal received at the inputs of the amplifier component decreases. The ten to twenty times smaller reactance value of the centre part with respect to the reactance values of the other two parts is found to be a good compromise.

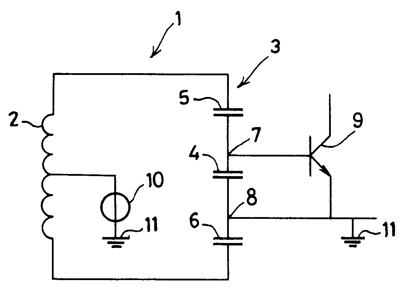

The invention is explained with reference to the drawing which shows a preferred embodiment of a tuned radio receiver circuit according to the invention.

The radio receiver circuit shown is indicated in its entirety by the reference numeral 1 and comprises a parallel circuit of a self-inductance 2 and a series circuit 3 comprising a centre capacitor 4 and two other capacitors 5 and 6 which are connected to the self-inductance 2. The junction 7 between the capacitor 4 and the capacitor 5 and the junction 8 between the capacitor 4 and the capacitor 6 are connected to the base and emitter, respectively, of an amplifier component formed by a transistor 9.

The values of the self-inductance 2 and of the capacitors 4, 5 and 6 are chosen so that the circuit 1 is tuned to a frequency of a transmission signal transmitted by a transmitter.

As the chosen value of the capacitor 4 becomes greater, as a result of which the reactance at the tuning frequency thereof decreases, the tuned circuit 1 is loaded to a lesser extent by the transistor 9, and as a result of this the reception sensitivity increases.

If, as is known per se in the case of portable receiving units of a paging system, an (important) interference source 10 is arranged symmetrically with respect to the tuned circuit 1, in particular, to the self-inductance 2, this can be interpreted as if the source interference 10 is connected between a centre terminal of the self-inductance 2 and earth 11. A portion of the interference signal current will then flow via the capacitor 5 to the junction 7 and another portion will flow via the capacitor 6 to the junction 8. If the values of the capacitors 5 and 6 are then equal, these currents will essentially cancel each other out, and this improves the signal/noise ratio.

It has been found that a value of the capacitor 4 which is 10 to 20 times greater than that of the capacitor 5 and of the capacitor 6 gives good results. With a ratio of 10, the interference signal is then suppressed by approximately 20 log (1/1+10) = 21 dB. If an input amplifier stage containing, for example, the transistor 9 were to be connected asymmetrically, i.e. without the capacitor 6, to the tuned circuit 1 instead of symmetrically, the value of the capacitor 4 would have to remain unchanged and the value of the capacitor 5 would have to be halved for the tuned circuit to be identically loaded. The strength of the transmission signal received therefore remains the same. Consequently, in the example, the symmetrical coupling according to the invention achieves an improvement in the signal/noise ratio or the sensitivity with respect to the known asymmetric coupling of not more than 21 dB, this being limited, however, by the sensitivity of the input stage.

Within the scope of the invention, embodiments of the tuned circuit other than the embodiment shown are possible. The chosen values of the capacitors 5 and 6 may, for example, be different depending on the position of the interference source 10 with respect to the tuned circuit 1. Furthermore, the self-inductance 2 can be replaced by a capacitor and self-inductances can then be used instead of the capacitors 4, 5 and 6, the centre self-inductance then having a smaller value than the other two self-inductances.

## Claims

1. Tuned radio receiving circuit (1) comprising a parallel circuit of two reactances (2, 3) having opposite polarities, one of the reactances (3) having terminals (7, 8) for connection to an amplifier component (9) and comprising a series circuit (3) of three parts having the same polarity, the amplifier component being connected across the centre part (4) thereof, **characterized in that** said centre part (4) has a reactance value at a tuning frequency of the circuit ten to twenty times smaller than the reactance values of the other two parts (5, 6) in order to minimise an interference signal generated by an interference source (10) at an input of the amplifier component, and in that the amplifier component (9) is a transistor having a control terminal and another terminal, said terminals being connected to the terminals (7, 8) of the centre part of the series circuit.

2. Tuned radio receiver circuit according to claim 1, **characterized in that** the reactance values of the other two parts (5, 6) of the series circuit (3) are essentially equal.

3. Tuned radio receiving circuit according to claim 1 or 2, **characterized in that** the one reactance (3) is a capacitor and the other reactance (2) a self-inductance.

## Patentansprüche

1. Abgestimmte Radioempfängerschaltung (1) mit einer Parallelschaltung von zwei Reaktanzen (2, 3) entgegengesetzter Polaritäten, wobei die eine der Reaktanzen (3) Anschlüsse (7, 8) zur Verbindung mit einer Verstärkerkomponente (9) hat und eine Serienschaltung (3) aus drei Teilen aufweist, die dieselbe Polarität haben, wobei die Verstärkerkomponente über dessen Zentralteil (4) verbunden ist,
**dadurch gekennzeichnet**, daß
der Zentralteil (4) einen Reaktanzwert bei einer Abstimmfrequenz der Schaltung hat, welcher zehn bis zwanzig Mal kleiner ist als die Reaktanzwerte der anderen zwei Teile (5, 6), um ein Störsignal zu minimieren, das von einer Störquelle (10) an einem Eingang der Verstärkerkomponente erzeugt worden ist, und daß die Verstärkerkomponente (9) ein Transistor ist, der einen Steueranschluß und einen weiteren Anschluß hat, und daß diese Anschlüsse mit den Anschlüssen (7, 8) des Zentralteils der Serienschaltung verbunden sind.

2. Abgestimmte Radioempfängerschaltung gemäß Anspruch 1, dadurch gekennzeichnet, daß die Reaktanzwerte der anderen zwei Teile (5, 6) der Serienschaltung (3) im wesentlichen gleich sind.

3. Abgestimmte Radioempfängerschaltung gemäß Anspruch 1 oder 2, dadurch gekennzeichnet, daß die eine Reaktanz (3) eine Kapazität und die andere Reaktanz (2) eine Selbstinduktanz ist.

## Revendications

1. Circuit récepteur radio accordé (1), comprenant un circuit parallèle de deux réactances (2, 3) ayant des polarités opposées, l'une des réactances (3) ayant des bornes (7, 8) en vue de la connexion à un composant amplificateur (9) et comprenant un circuit série (3) de trois parties ayant la même polarité, le composant amplificateur étant connecté à travers la partie centrale (4) de celui-ci, caractérisé par le fait que ladite partie centrale (4) présente une valeur de réactance à une fréquence d'accord du circuit de dix à vingt fois plus petite que les valeurs de réactance des deux autres parties (5, 6), de façon à minimiser un signal d'interférence produit par une source d'interférence (10) à une entrée du composant amplificateur, et par le fait que le composant amplificateur (9) est un transistor ayant une borne de commande et une autre borne, lesdites bornes étant connectées aux bornes (7, 8) de la partie centrale du circuit série.

2. Circuit récepteur radio accordé selon la revendication 1, caractérisé par le fait que les valeurs de réactance des deux autres parties (5, 6) du circuit série (3) sont sensiblement égales.

3. Circuit récepteur radio accordé selon la revendication 1 ou 2, caractérisé par le fait que la première réactance citée (3) est un condensateur, et l'autre réactance (2), une auto-inductance.
